Europäisches Patentamt

European Patent Office

Office européen des brevets

(19)

(11) Publication number: **0 451 843 A2**

# EUROPEAN PATENT APPLICATION

(21) Application number: 91105789.1

(22) Date of filing: 11.04.91

(51) Int. Cl.⁵: **H01L 33/00**, H01S 3/19, H04B 10/12

(30) Priority: **12.04.90 JP 97053/90**

(43) Date of publication of application:
**16.10.91 Bulletin 91/42**

(84) Designated Contracting States:
**DE FR GB IT NL**

(71) Applicant: **CANON KABUSHIKI KAISHA**
**30-2, 3-chome, Shimomaruko, Ohta-ku**
**Tokyo(JP)**

(72) Inventor: **Handa, Yuichi, c/o CANON**
**KABUSHIKI KAISHA**

30-2, 3-chome, Shimomaruko, Ohta-ku
Tokyo(JP)
Inventor: **Kaneko, Kumiko, c/o CANON**
**KABUSHIKI KAISHA**
30-2, 3-chome, Shimomaruko, Ohta-ku
Tokyo(JP)

(74) Representative: **Tiedtke, Harro, Dipl.-Ing. et al**
**Patentanwaltsbüro Tiedtke-Bühling-Kinne-**
**Grupe-Pellmann-Grams Bavariaring 4**
**Postfach 20 24 03**
**W-8000 München 2(DE)**

(54) Semiconductor device and method of manufacturing the same.

(57) A semiconductor device includes a substrate, a plurality of semiconductor layers stacked on the substrate and including an active layer having two opposite end faces, a first thin film coated on at least one of the end faces and consisting of a material having a stable composition and a high passivation function, a second thin film coated on the first thin film and having a predetermined refractive index, and electrodes for supplying a current to the active layer. A method of manufacturing the semiconductor device is also disclosed.

FIG. 4

## BACKGROUND OF THE INVENTION

### Field of the Invention

The present invention relates to a semiconductor device and a method of manufacturing the same and, more particularly, to a semiconductor device such as an optical amplifier for use in an optical communication system and a method of manufacturing the same.

### Related Background Art

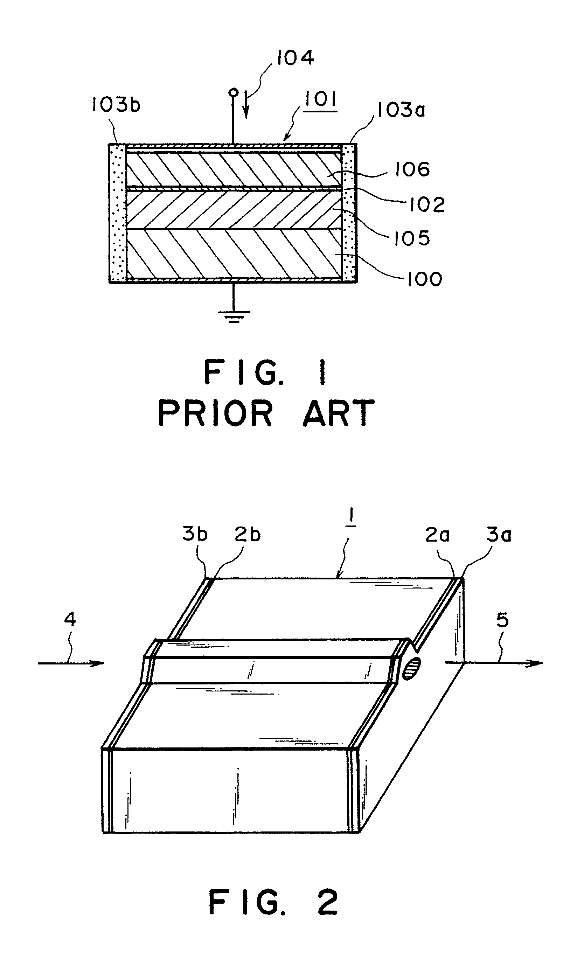

As shown in Fig. 1, a conventional semiconductor optical amplifier has a semiconductor laser structure 101 including an active layer 102 sandwiched between a lower cladding layer 105 and an upper cladding layer 106 formed on a substrate 100. Antireflection (AR) coatings 103a and 103b are formed on the cleavage end faces of the semiconductor laser structure 101 to suppress laser oscillation even when a high internal gain is applied upon injection of a current 104.

The quality of this AR coating has a large effect on the performance of a semiconductor optical amplifier, and the reflection factor of the AR coating must be decreased in order to suppress an increase/decrease in gain with respect to an input wavelength spectrum, i.e., a so-called gain ripple. Assuming that the gain ripple is 2 dB, the relationship between a single pass gain G and a reflection factor R of the AR coating is given by:

$$G \cdot R \leq 0.1.$$

For example, assuming that the gain is 20 dB, the refection factor is $R \leq 0.1\%$.

An optical amplifier in which the reflection factor R is reduced to eliminate the gain ripple with respect to the wavelength spectrum is effectively used in optical amplification of a multiple wavelength multiplexing signal and is called a traveling wave type optical amplifier.

In order to form each of the AR coatings 103a and 103b, a dielectric film having a desired refractive index is normally deposited on the cleavage end face to have a thickness of $\lambda/4$ assuming that the wavelength of light to be amplified is $\lambda$, as shown in Fig. 1. In this case, although the desired refractive index changes in accordance with the type of semiconductor material used or waveguide structure, the value of an optimal refractive index $n$ is about $n \cong 1.85$ in a GaAs/AlGaAs-based laser.

Since, however, it is difficult to achieve the above refractive index by only a dielectric material having a stable composition, evaporation conditions are normally controlled by, e.g., electron-beam (EB) evaporation to achieve this refractive index.

For example, it is reported that an oxygen supply amount of $SiO_2/SiO$ is controlled to realize an $SiO_x$ $(1 < x < 2)$ composition, thereby achieving an antireflection coating with a reflection factor of 0.01% or less in an InP-based semiconductor optical amplifier.

In addition, studies have been conventionally made on a method of performing EB evaporation using a $ZrO_2/Al_2O_3$ mixed sintered body as a material or a method of controlling a supply oxygen partial pressure using $ZrO_2$ or Zr as a material to control a refractive index.

The above materials are only examples, and not only an oxide but also a nitride can be used.

In addition, a sputtering method or the like can be used as well as the electron-beam evaporation. For example, a so-called reactive sputtering method of executing partial pressure control of a supply gas may be used to perform refractive index control.

However, in the above conventional semiconductor optical amplifier in which the composition ratio of the AR coating material is controlled to realize a desired refractive index, the following problems are posed because the composition of a thin film is shifted from a stable composition.

(1) Since the AR coating composition is shifted from the stable composition, evaporation is performed while several stable compositions are combined, e.g., in a state of $SiO + SiO_2$ in the case of $SiO_x$. Therefore, it is difficult to maintain stable manufacturing conditions due to a material melting point difference or a packing density difference.

(2) Similarly, since the composition is shifted from the stable composition, the packing density of the thin film of the AR coating is low. Therefore, the function of protection of the semiconductor end faces, i.e., passivation or inactivation is degraded to significantly degrade the durability and the life of a device as an output light amount is increased.

## SUMMARY OF THE INVENTION

It is an object of the present invention to provide a semiconductor device which solves the above conventional problems, has high durability, and can be manufactured under stable conditions and a method of manufacturing the same.

The above object of the present invention is achieved by a semiconductor device comprising:

a substrate;

a plurality of semiconductor layers laminated on the substrate and including an active layer having two opposite end faces;

a first thin film coated on at least one of the end faces and consisting of a material having a stable composition and a high passivation function;

a second thin film coated on the first thin film and having a predetermined refractive index; and

electrodes for supplying a current to the active layer.

A semiconductor optical amplifier as one aspect of the present invention comprises:

a substrate;

a first cladding layer formed on the substrate;

an active layer formed on the first cladding layer and having two opposite end faces to constitute a resonant cavity;

a second cladding layer formed on the active layer;

a first thin film coated on each of the end faces and consisting of a material having a stable composition and a high passivation function;

a second thin film coated on each of the first thin films and having a predetermined refractive index, the first and second thin films reducing reflection factors of the end faces with respect to light to be amplified; and

electrodes for supplying a current to the active layer.

An external resonator type semiconductor laser as another aspect of the present invention comprises:

a substrate;

a plurality of semiconductor layers stacked on the substrate and including an active layer having two opposite end faces;

a first thin film coated on one of the end faces and consisting of a material having a stable composition and a high passivation function;

a second thin film coated on the first thin films and having a predetermined refractive index, the first and second thin films reducing reflection factors of the end faces;

a grating, formed to oppose the end face coated with the first and second thin films, for diffracting a portion of light emitted from the end face and returning the diffracted light onto the end face; and

electrodes for supplying a current to the active layer.

An optical communication system using the optical amplifier of the present invention comprises:

(a) an optical transmitter;

(b) an optical receiver;

(c) an optical transmission path for connecting the optical transmitter and the optical receiver; and

(d) a semiconductor optical amplifier provided in the optical transmission path and comprising:

a substrate;

a plurality of semiconductor layers stacked on the substrate and including an active layer having two opposite end faces to constitute a resonant cavity;

a first thin film coated on each of the end faces and consisting of a material having a stable composition and a high passivation function;

a second thin film coated on each of the first thin films and having a predetermined refractive index, the first and second thin films reducing reflection factors of the end faces with respect to light to be amplified; and

electrodes for supplying a current to the active layer.

A method of manufacturing the semiconductor laser as described above comprises the steps of:

stacking a plurality of semiconductor layers including an active layer on a substrate;

cleaving the semiconductor layers to form two opposite resonant surfaces;

coating a first thin film consisting of a material having a stable composition and a high passivation function on at least one of the resonant surfaces; and

coating the second thin film on the first thin film to have a predetermined refractive index.

As described above, the present invention is characterized in that a very thin film (e.g., several tens to several hundreds Å) having a stable composition ratio and a high passivation function is formed as the first layer on the semiconductor end face and conventional thin films having desired refractive indexes by controlling composition ratios are formed as the second and subsequent layers, thereby achieving an AR coating which realizes a device with high durability and high reproducibility. More specifically, the two conditions required for the AR coating, i.e., ① the AR condition (adjustment of the refractive index and the depth of a layer) and ② the passivation condition are simultaneously satisfied by a combination of two different types of thin films.

In this case, the expression "passivation function is high" means that a thin film is not easily changed, is stable over a long time period, and has a large effect of preventing ingress of oxygen from outside into the end face to prevent oxidation on the end face.

BRIEF DESCRIPTION OF THE DRAWINGS

Fig. 1 is a schematic sectional view showing an example of a conventional semiconductor optical amplifier;

Fig. 2 is a schematic perspective view showing a semiconductor optical amplifier as the first embodiment of the present invention;

Fig. 3 is a block diagram showing an arrangement of an optical communication system using an optical amplifier of the present invention;

Fig. 4 is a front sectional view showing the optical amplifier shown in Fig. 2;

Fig. 5 is a side sectional view showing the optical amplifier shown in Fig. 2;

Fig. 6 is graph showing a relationship between the depth of a layer of the second thin film and the refractive index of the end face; and

Fig. 7 is a schematic sectional view showing an external resonant semiconductor laser as the second embodiment of the present invention.

DETAILED DESCRIPTION OF THE PREFERRED EMBODIMENTS

Fig. 2 is a perspective view showing the first embodiment of a semiconductor optical amplifier of the present invention. In this first embodiment, a ridge type laser 1 is adopted as a basic semiconductor laser structure. The cleavage end face consists of a two-layered coating material. First thin films 2a and 2b on the semiconductor end face side (inside) are constituted by $Al_2O_3$ sputtered films (thickness = 100 Å) consisting of a dense material having a stable composition and a satisfactory passivation function. Second thin films 3a and 3b are constituted by $ZrO_2$ electron-beam (EB) evaporated films formed by controlling the composition by $O_2$ gas supply. These thin films are formed while real-time optical monitoring is performed such that the total thickness of the films 2a and 3a and that of the films 2b and 3b become equal to $\lambda/4$ ($\lambda$ is the wavelength of light to be amplified). An AR coating constituted by these thin films can be formed on an element obtained by cleaving a wafer into bars or an element mounted on a stem.

It is found upon measurement of a gain ripple that in the semiconductor optical amplifier manufactured as described above, the reflection factor of the AR coating can be easily decreased to be 0.1% or less.

A current slightly lower than a threshold current is injected to the semiconductor optical amplifier, and a light wave 4 is externally input through a lens or an optical fiber and supplied to the semiconductor optical amplifier, thereby obtaining an amplified light wave 5. As a result, an internal gain of 20 to 30 dB can be achieved.

The section of the first embodiment is basically the same as that of a structure shown in Fig. 1.

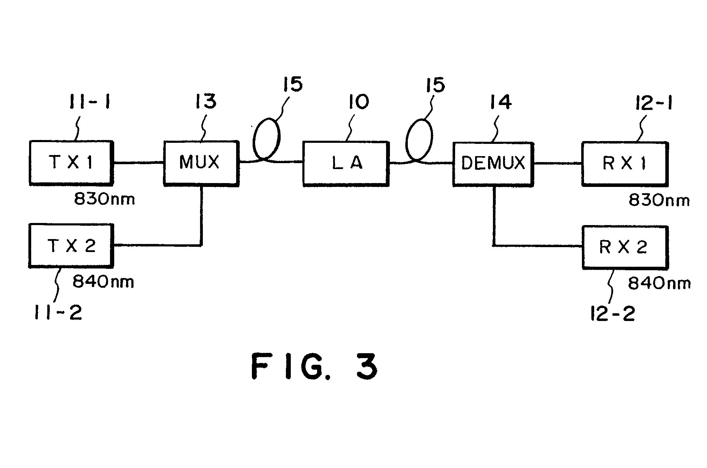

Fig. 3 is a block diagram showing an arrangement in which the device of the above embodiment is applied to a wavelength multiplex transmission/reception system. The system shown in Fig. 3 comprises the optical amplifier LA 10 described above, optical transmitters TX1 11-1 and TX2 11-2, optical receivers RX1 12-1 and RX2 12-2, a multiplexer 13, a demultiplexer 14, and a transmission optical fiber 15. With this arrangement, since light signals having wavelengths of 830 and 840 nm can be multiplexed and amplified with a high gain and a low ripple by the optical amplifier 10, signals free from crosstalk can be transmitted/received at a transmission rate of 100 Mbps or more.

As described above, it is found that, when an $Al_2O_3$ sputtered film having a high passivation function is used as the first thin film and a $ZrO_2$ electron-beam evaporated film having a controlled refractive index is used as the second thin film, a semiconductor optical amplifier which can stably perform an amplification operation even at a high light output and has an AR coating having high durability and low reflection conditions can be obtained.

A device arrangement and a manufacturing method of this embodiment will be described below.

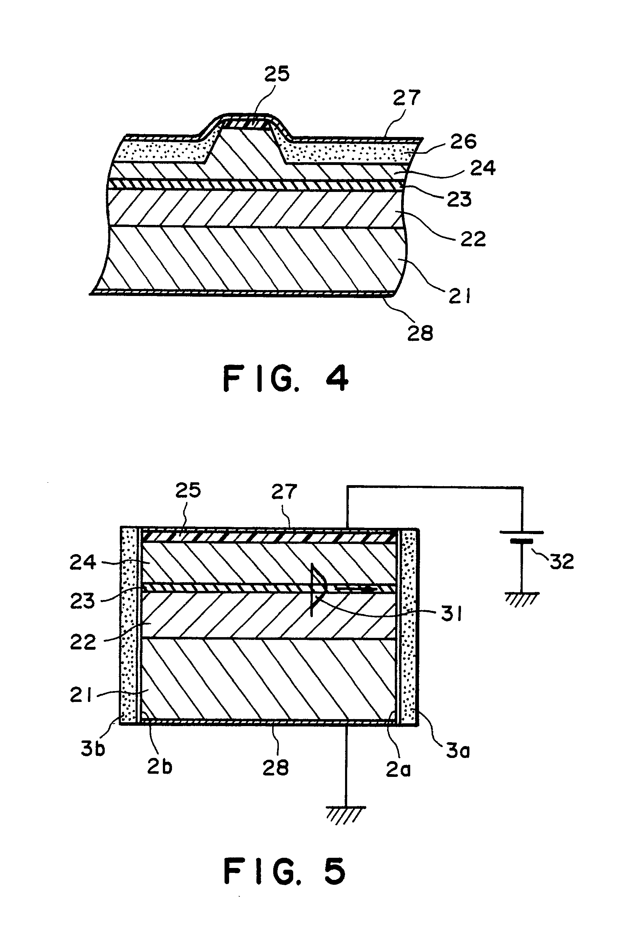

Figs. 4 and 5 are views for explaining a practical arrangement of the semiconductor optical amplifier shown in Fig. 2. Fig. 4 is a schematic sectional view showing the section of the optical amplifier in a direction perpendicular to the resonant direction, and Fig. 5 is a schematic view showing the section of the optical amplifier in a direction along the resonant direction.

The arrangement shown in Figs. 4 and 5 comprises an n-type GaAs substrate 21, an n-type $Al_xGa_{1-x}As$ cladding layer 22 (Al crystal mixing ratio x = 0.3), a GaAs active layer 23, a p-type AlGaAs (x = 0.3) cladding layer 24, and a $p^+$-type cap layer 25. These epitaxial films are grown by, e.g., a molecular beam epitaxial (MBE) method or an organic metal-chemical vapor deposition (MO-CVD) method. Subsequently, after a ridge portion is patterned by photolithography, a ridge portion having a width of 2 to 3 $\mu$m and a thickness to the active layer 23 of 0.3 to 0.4 $\mu$m is formed by a reactive ion beam etching (RIBE) method. An $SiN_x$ film 26 is deposited, and a window is formed to enable current injection from the cap layer 25. Au films are deposited on the upper and lower surfaces and alloyed to form ohmic electrodes 27 and 28.

A laser wafer subjected to the above process is cleaved into bars or chips and subjected to a coating treatment. The two end faces formed by the cleavage parallelly face each other to form laser resonant surfaces. That is, the active layer present between these end faces constitutes a resonant cavity.

Referring to Fig. 5 showing the layer arrangement of an AR coating, $Al_2O_3$ films 2a and 2b are deposited by sputtering to have a thickness of 100 Å immediately after the cleavage is executed at an RF power of 100 W. The durability of the $Al_2O_3$ films 2a and 2b formed in this manner exceeds 10,000 hours when it is evaluated as passivation of a laser. In this case, the thickness of the $Al_2O_3$ film need only be about 100 Å.

As described above, the second thin films 3a and 3b are formed to have a refractive index of 1.85 to 1.86 by controlling an oxygen supply amount by electron-beam (EB) evaporation using $ZrO_2$ as a material. This control of the depth of a layer is performed using a monitor sample by a real-time monitoring method such as a method of monitoring the front or rear output of a constant-current-driven laser or a method of monitoring light reflected by a quartz substrate, and the AR conditions are realized such that the sum of the depths of layers of the first and second films becomes $\lambda/4$. Note that the first and second films must be deposited on the monitor sample to have the same depth of thickness as that of a real sample.

The semiconductor optical amplifier of the first embodiment is driven as follows. First, a voltage is applied by a power source 32 across the electrodes 27 and 28 in a forward bias manner to inject a current into the active layer 23. The amount of the injected current is adjusted to be smaller than a threshold value of laser oscillation. That is, an injected current density is set such that this optical amplifier does not cause laser oscillation by only injection of a current.

Light is caused to become incident from one end face of the optical amplifier into the active layer. Upon incidence of this light, induced emission is caused in the resonant cavity constituted by the active layer between the two end faces. Amplified light is emitted from the other end face of the optical amplifier.

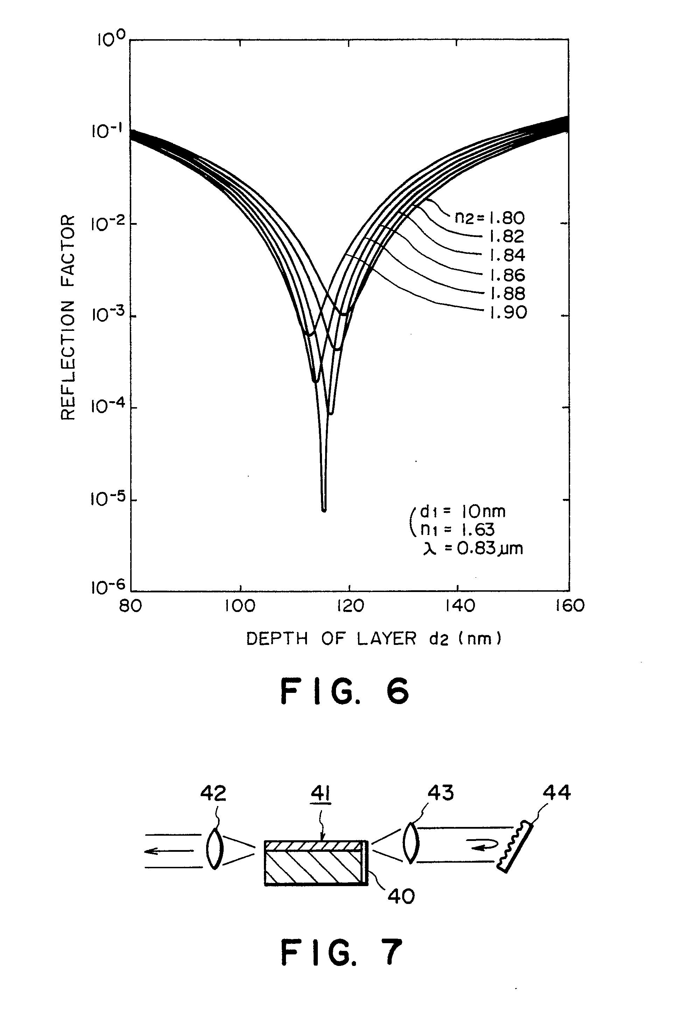

Fig. 6 shows a relationship between the reflection factor of waveguide light 31 having a wavelength of 0.83 $\mu$m and a depth of layer $d_2$ of the second thin films 3a and 3b obtained when the thickness of the active layer 23 is 0.1 $\mu$m. Note that the first thin films 2a and 2b consist of $Al_2O_3$ films having a refractive index $n_1$ = 1.63 and a depth of layer $d_1$ = 100 Å (10 nm). Each curve is obtained by changing a refractive index $n_2$ of the second thin film as a parameter within a range of 1.80 to 1.90. It is apparent from Fig. 6 that a reflection factor of substantially 0.01% can be realized when the refractive index of the second thin films is $n_2$ = 1.85 to 1.86.

The refractive index control according to EB evaporation can be satisfactorily executed within the above allowable range (1.80 to 1.90), and it is comparatively easy to realize an AR coating with a reflection factor of 0.1% ($10^{-3}$) or less even when a variation in the manufacture is taken into consideration. In addition, since an allowable range of an error of the depth of layer control is assumed to be about 5 nm in Fig. 6, real-time monitoring can be satisfactorily executed by setting the evaporation rate to be several Å/sec or less.

The sample subjected to the AR coating as described above is scribed into chips and subjected to die bonding or wire bonding to complete mounting. Although $Al_2O$, sputtered films are used as the first passivation thin films 2a and 2b in the above embodiment, $SiO_2$ sputtered films may be used as a modification. This composition is also stable and therefore can be used as a thin film having a high passivation function.

Fig. 7 shows the second embodiment in which the present invention is applied to an external resonator type laser. In the second embodiment, an AR coating 40 is formed on only one end face, and the other end face is subjected to $\lambda/2$ coating using a thin film having a stable composition or is noncoated.

A film arrangement and a manufacturing process of this semiconductor laser 41 in which only one end face is subjected to AR coating are exactly the same as those of the first embodiment. The external resonator laser comprises front and rear lenses 42 and 43, a semiconductor laser 41, and a reflection blazed grating 44.

When a current exceeding a threshold current is supplied to an active layer by an electrode of the semiconductor laser 41, the active layer emits light. The light emitted from the active layer is incident from the end face having the AR coating 40 onto the grating 44. Of the incident light, this grating 44 diffracts light having a predetermined wavelength which satisfies Bragg conditions and returns the diffracted light from the end face into the active layer. Laser oscillation is caused by this diffraction of the grating 44, and laser light having a predetermined wavelength is emitted from the other end face of the semiconductor laser 41 not having the AR coating 40. The oscillation wavelength can be selected by changing the incident angle of the light wave onto the grating 44. When a GaAs layer is used as the active layer, a wavelength selection width of 20 nm or more is achieved, and a high output operation of 5 mW or more is stably executed. In this manner, it is confirmed that the durability of the AR coating 40 in which light power concentration occurs is improved.

The present invention can be carried out in various applications other than the above-mentioned embodiments. For example, the present invention can be applied to not only the optical amplifier and the external resonator type semiconductor laser described above but also any semiconductor device such as a super luminescence diode as long as it requires a coating for adjusting the reflection factor of the end face. The present invention includes all of these applications not departing from the scope of claims.

A semiconductor device includes a substrate, a plurality of semiconductor layers stacked on the substrate and including an active layer having two opposite end faces, a first thin film coated on at least one of the end faces and consisting of a material having a stable composition and a high passivation function, a second thin film coated on the first thin film and having a predetermined refractive index, and electrodes for supplying a current to the active layer. A method of manufacturing the semiconductor device is also disclosed.

## Claims

1. A semiconductor device comprising:

   a substrate;

   a plurality of semiconductor layers laminated on said substrate and including an active layer having two opposite end faces;

   a first thin film coated on at least one of said end faces and consisting of a material having a stable composition and a high passivation function;

   a second thin film coated on said first thin film and having a predetermined refractive index; and

   electrodes for supplying a current to said active layer.

2. A device according to claim 1, wherein said first thin film consists of one of $Al_2O_3$ and $SiO_2$ and said second thin film consists of $ZrO_2$.

3. A device according to claim 1, wherein a depth of layer of said first thin film falls within a range of several tens to several hundreds Å, and a sum of the depth of layer of said first thin film and that of said second thin film is equal to $\lambda/4$ assuming that a wavelength of light emitted from said semiconductor device is $\lambda$.

4. A semiconductor device comprising:

   a substrate;

   a first cladding layer formed on said substrate;

   an active layer formed on said first cladding layer and having two opposite end faces to constitute a resonant cavity;

   a second cladding layer formed on said active layer;

   a first thin film coated on at least one of said end faces and consisting of a material having a stable composition and a high passivation function;

   a second thin film coated on said first thin film to have a predetermined refractive index; and

   electrodes for supplying a current to said active layer.

5. A device according to claim 4, wherein said first thin film consists of one of $Al_2O_3$ and $SiO_2$ and said second thin film consists of $ZrO_2$.

6. A device according to claim 4, wherein a depth of layer of said first thin film falls within a range of several tens to several hundreds Å, and a sum of the depth of layer of said first thin film and that of said second thin film is equal to $\lambda/4$ assuming that an oscillation wavelength of said resonant cavity is $\lambda$.

7. A device according to claim 4, wherein said substrate and said first cladding layer consist of an n-type semiconductor, and said second cladding layer consists of a p-type semiconductor.

8. A device according to claim 7, wherein said substrate and said active layer consist of GaAs and said first and second cladding layers consist of AlGaAs.

9. A device according to claim 4, wherein said second cladding layer has a stripe-like ridge portion extending in a resonant direction.

10. A semiconductor optical amplifier comprising:

    a substrate;

    a first cladding layer formed on said substrate;

    an active layer formed on said first cladding layer and having two opposite end faces to constitute a resonant cavity;

    a second cladding layer formed on said active layer;

    a first thin film coated on each of said end faces and consisting of a material having a stable composition and a high passivation function;

    a second thin film coated on each of said first thin films and having a predetermined refractive index, said first and second thin films reducing reflection factors of said end faces with respect to light to be amplified; and

    electrodes for supplying a current to said active layer.

11. A device according to claim 10, wherein said first thin film consists of one of $Al_2O_3$ and $SiO_2$ and said second thin film consists of $ZrO_2$.

12. A device according to claim 10, wherein a depth of layer of said first thin film falls within a range of several tens to several hundreds Å, and a sum of the depth of layer of said first thin film and that of said second thin film is equal to $\lambda/4$ assuming that an oscillation wavelength of said resonant cavity is λ.

13. A device according to claim 10, wherein said substrate and said first cladding layer consist of an n-type semiconductor, and said second cladding layer consists of a p-type semiconductor.

14. A device according to claim 13, wherein said substrate and said active layer consist of GaAs and said first and second cladding layers consist of AlGaAs.

15. A device according to claim 10, wherein said second cladding layer has a stripe-like ridge portion extending in a resonant direction.

16. A device according to claim 10, wherein the reflection factors of said two end faces are not more than 0.1%.

17. An optical amplifier apparatus comprising:
    a substrate consisting of an n-type semiconductor;
    a first cladding layer formed on said substrate and consisting of an n-type semiconductor;
    a semiconductor active layer formed on said first cladding layer and having two opposite end faces to constitute a resonant cavity;
    a second cladding layer formed on said active layer and consisting of a p-type semiconductor;
    a first thin film coated on each of said end faces and consisting of a material having a stable composition and a high passivation function;
    a second thin film coated on each of said first thin films and having a predetermined refractive index, said first and second thin films reducing reflection factors of said end faces with respect to light to be amplified;
    a first electrode formed on a bottom surface of said substrate;
    a second electrode formed on said second cladding layer; and
    a power source for applying a voltage in a forward bias direction across said first and second electrodes.

18. A device according to claim 17, wherein said first thin film consists of one of Al₂O₃ and SiO₂ and said second thin film consists of ZrO₂.

19. A device according to claim 17, wherein a depth of layer of said first thin film falls within a range of several tens to several hundreds Å, and a sum of the depth of layer of said first thin film and that of said second thin film is equal to λ/4 assuming that an oscillation wavelength of said resonant cavity is λ.

20. A device according to claim 17, wherein said substrate and said active layer consist of GaAs and said first and second cladding layers consist of AlGaAs.

21. A device according to claim 17, wherein said second cladding layer has a stripe-like ridge portion extending in a resonant direction.

22. A device according to claim 17, wherein the reflection factors of said two end faces are not more than 0.1%.

23. An external resonator type semiconductor laser comprising:
    a substrate;
    a plurality of semiconductor layers laminated on said substrate and including an active layer having two opposite end faces;
    a first thin film coated on one of said end faces and consisting of a material having a stable composition and a high passivation function;
    a second thin film coated on said first films and having a predetermined refractive index, said first and second thin films reducing reflection factors of said end faces;
    a grating, formed to oppose said end face coated with said first and second thin films, for diffracting a portion of light emitted from said end face and returning the diffracted light onto said end face; and
    electrodes for supplying a current to said active layer.

24. A device according to claim 23, wherein said first thin film consists of one of Al₂O₃ and SiO₂ and said second thin film consists of ZrO₂.

25. A device according to claim 23, wherein a depth of layer of said first thin film falls within a range of several tens to several hundreds Å, and a sum of the depth of layer of said first thin film and that of said second thin film is equal to λ/4 assuming that a wavelength of the light is λ.

26. An optical communication system comprising:
    (a) an optical transmitter;
    (b) an optical receiver;
    (c) an optical transmission path for connecting said optical transmitter and said optical receiver; and

(d) a semiconductor optical amplifier provided in said optical transmission path and comprising:

a substrate;

a plurality of semiconductor layers laminated on said substrate and including an active layer having two opposite end faces to constitute a resonant cavity;

a first thin film coated on each of said end faces and consisting of a material having a stable composition and a high passivation function;

a second thin film coated on each of said first thin films and having a predetermined refractive index, said first and second thin films reducing reflection factors of said end faces with respect to light to be amplified; and

electrodes for supplying a current to said active layer.

27. A device according to claim 26, wherein said first thin film consists of one of $Al_2O_3$ and $SiO_2$ and said second thin film consists of $ZrO_2$.

28. A device according to claim 26, wherein a depth of layer of said first thin film falls within a range of several tens to several hundreds Å, and a sum of the depth of layer of said first thin film and that of said second thin film is equal to $\lambda/4$ assuming that an oscillation wavelength of said resonant cavity is $\lambda$.

29. A method of manufacturing a semiconductor laser constituted by a substrate and a plurality of semiconductor layers formed on said substrate and including an active layer, comprising the steps of:

laminating said plurality of semiconductor layers including said active layer on said substrate;

cleaving said semiconductor layers to form two opposite resonant surfaces;

coating a first thin film consisting of a material having a stable composition and a high passivation function on at least one of said resonant surfaces; and

coating said second thin film on said first thin film to have a predetermined refractive index.

30. A method according to claim 29, wherein said first thin film consists of one of $Al_2O_3$ and $SiO_2$ and said second thin film consists of $ZrO_2$.

31. A method according to claim 30, wherein said first thin film is formed by sputtering, and said second thin film is formed by electron-beam evaporation.

32. A method according to claim 29, wherein said first thin film is formed to have a depth of layer of several tens to several hundreds Å, and a sum of a depth of layer of said first thin film and that of said second thin film is equal to $\lambda$ assuming that a resonant frequency of said two resonant surfaces is $\lambda$.

# FIG. 1
# PRIOR ART

# FIG. 2

9

FIG. 3

FIG. 4

FIG. 5

$$\begin{pmatrix} d_1 = 10nm \\ n_1 = 1.63 \\ \lambda = 0.83\,\mu m \end{pmatrix}$$

REFLECTION FACTOR

DEPTH OF LAYER $d_2$ (nm)

$n_2 = 1.80$
1.82
1.84
1.86
1.88
1.90

# F I G. 6

# F I G. 7